# EUROPEAN PATENT APPLICATION

(11) **EP 4 578 358 A1**
(43) Date of publication of application: **02.07.2025**
(21) Application number: 23856456.1
(22) Date of filing: 07.08.2023
(51) Int. Cl.: A47L 11/24, A47L 11/40, A47L 11/28

(54) **AUTOMATIC CLEANING DEVICE, AND SYSTEM**

(30) Priority: 22.08.2022 CN 202222205872 U; 02.09.2022 CN 202222346054 U
(71) Applicant: Beijing Roborock Technology Co., Ltd., Beijing 102206 (CN)
(72) Inventor: GAO, Lifeng, Beijing 102206 (CN); ZHAO, Degang, Beijing 102206 (CN); YU, Luping, Beijing 102206 (CN)
(74) Representative: Behr, Wolfgang
(86) International application number: PCT/CN2023/111569
(87) International publication number: WO 2024/041366

(57) **Abstract**

An automatic cleaning device, comprising: a mobile platform; a circuit board, which is arranged in the mobile platform and comprises a circuit board body provided with a middle area and an edge area surrounding the middle area; interface devices arranged on the circuit board body and located in the edge area; electronic devices arranged on the circuit board body and located in the middle area; and a blocking rib arranged between the interface devices and the electronic devices and configured to block liquid and/or moisture from coming into contact with the electronic devices.

## Description

### CROSS-REFERENCE TO RELATED APPLICATION

This application claims priority of the Chinese Patent Application No. 202222205872.4, filed on August 22, 2022, and the Chinese Patent Application No. 202222346054.6, filed on September 2, 2022, which are incorporated herein by reference in their entireties.

### TECHNICAL FIELD

The present disclosure relates to the technical field of cleaning robots, and particularly to an automatic cleaning apparatus and system.

### BACKGROUND ART

With the continuous development of science and technology, cleaning robots are becoming increasingly popular, which brings convenience to family life. Automatic cleaning apparatuses include, for example, sweeping robots, mopping robots and sweeping-mopping integrated robots. With the popularization of automatic cleaning apparatuses, the functions and structures of cleaning robots are increasingly complex.

When an automatic cleaning apparatus is set to operate in an environment with higher humidity (such as a kitchen and a bathroom), there is a risk of water ingress into the machine, which threatens elements such as a circuit board, causes damage to devices, and further damages the automatic cleaning apparatus.

### SUMMARY OF THE INVENTION

Some embodiments of the present disclosure provide an automatic cleaning apparatus, including:
a mobile platform;
a circuit board, disposed in the mobile platform and including:
   a circuit board body having a middle area and a peripheral area around the middle area;
   a port device, disposed on the circuit board body and located in the peripheral area; and
   an electronic device, disposed on the circuit board body and located in the middle area; and
   a retaining rib, disposed between the port device and the electronic device, and configured to prevent liquid and/or moisture from being in contact with the electronic device.

In some embodiments, the retaining rib is of a semi-enclosure structure and is disposed around the port device, the semi-enclosure structure is provided with an open orifice, and the open orifice is disposed facing away from the middle area.

In some embodiments, the retaining rib includes:
a first subordinate retaining rib, disposed between the port device and the electronic device, and having a first end part and a second end part;
a second subordinate retaining rib, extending from the first end part to the peripheral area; and
a third subordinate retaining rib, extending from the second end part to the peripheral area, wherein
in the direction from the first subordinate retaining rib to the open orifice, the second subordinate retaining rib and the third subordinate retaining rib gradually diverge from each other.

In some embodiments, the retaining rib extends along an edge of the middle area, is disposed around the electronic device, and is of a full-enclosure structure.

In some embodiments, the mobile platform includes:
a mobile platform body, on which the circuit board is disposed; and
a platform cap body, detachably buckled on the mobile platform body to shield the circuit board, wherein
the retaining rib is disposed on a surface of the platform cap body facing the mobile platform body.

In some embodiments, when the platform cap body is buckled on the mobile platform body, a gap exists between the retaining rib and the circuit board body, and the gap d satisfies 0<d≤ 0.2 mm.

In some embodiments, the retaining rib and the platform cap body are of an integrated structure.

In some embodiments, when the platform cap body is buckled on the mobile platform body, the retaining rib rests against the circuit board body.

In some embodiments, the retaining rib is made of an elastic material.

In some embodiments, the retaining rib is disposed on the circuit board body.

Some embodiments of the present disclosure further provide a cleaning apparatus, including:
a mobile platform, configured to move on an operating surface;
a pile searching module, disposed on a side of the mobile platform and configured to receive a pile signal transmitted from a base station so as to identify the position of the base station; and
a stray light extinction structure, configured to extinct an interference signal of the pile signals when the pile searching module receives the pile signal.

In some embodiments, the pile searching module includes a signal window configured to receive the pile signal, and the stray light extinction structure is disposed at an edge position of the signal window.

In some embodiments, the stray light extinction structure surrounds the signal window.

In some embodiments, the stray light extinction structure is an oblique surface surrounding the signal window, and the oblique surface is a rough surface.

In some embodiments, the stray light extinction structure is an oblique surface surrounding the signal window, and the oblique surface is black or translucent black.

In some embodiments, the stray light extinction structure is an oblique surface surrounding the signal window, and the oblique surface is provided with a light absorption layer.

In some embodiments, the stray light extinction structure is an oblique surface surrounding the signal window, and the oblique surface is provided with a light extinction structure.

In some embodiments, the light extinction structure includes a micro protrusion disposed on the oblique surface.

In some embodiments, the micro protrusion includes at least one of the following: an arc-shaped protrusion, a cone-shaped protrusion or a prismatic protrusion.

In some embodiments, the stray light extinction structure is a vertical surface surrounding the signal window, and the vertical surface is perpendicular to the signal window.

In some embodiments, the mobile platform includes a water tank, and the stray light extinction structure is integrally formed with or separately formed with the water tank.

Some embodiments of the present disclosure further provide a cleaning system, including: a cleaning base station and the cleaning apparatus in any of the above items.

The embodiments of the present disclosure have the following technical effects.

The retaining rib is disposed in the mobile platform to prevent liquid and/or moisture from being in contact with the electronic device on the circuit board, so that damage to the electronic device is avoided, thereby guaranteeing the service life of the automatic cleaning apparatus.

### BRIEF DESCRIPTION OF THE DRAWINGS

The accompanying drawings herein, which are incorporated into the Description and constitute a part of the Description, show embodiments conforming to the present disclosure, and are used to explain the principles of the present disclosure together with the Description. Apparently, the accompanying drawings in the following description show merely some embodiments of the present disclosure, and those of ordinary skill in the art can also derive other accompanying drawings from these accompanying drawings without creative efforts. In the accompanying drawings:
FIG. 1 is a schematic diagram of a structure of an automatic cleaning apparatus according to some embodiments of the present disclosure;
FIG. 2 is a schematic diagram of a bottom structure of an automatic cleaning apparatus according to some embodiments of the present disclosure;
FIG. 3 is a schematic diagram of a structure of a mobile platform body of a mobile platform of an automatic cleaning apparatus according to some embodiments of the present disclosure;
FIG. 4 is an exploded schematic diagram of a structure of a mobile platform of an automatic cleaning apparatus according to some embodiments of the present disclosure;
FIG. 5 is an exploded schematic diagram of a structure of a mobile platform of an automatic cleaning apparatus according to some embodiments of the present disclosure;
FIG. 6 is a schematic diagram of a structure of a platform cap body of a mobile platform of an automatic cleaning apparatus according to some embodiments of the present disclosure;
FIG. 7 is an enlarged schematic diagram of an area N shown in FIG. 6;
FIG. 8 is an exploded schematic diagram of a structure of a mobile platform of an automatic cleaning apparatus according to some embodiments of the present disclosure;
FIG. 9 is an exploded schematic diagram of a structure of a mobile platform of an automatic cleaning apparatus according to some embodiments of the present disclosure;
FIG. 10 is a schematic diagram of a structure of a platform cap body of a mobile platform of an automatic cleaning apparatus according to some embodiments of the present disclosure;
FIG. 11 is a schematic diagram of a structure of a signal window of an automatic cleaning apparatus according to some embodiments of the present disclosure;
FIG. 12 is a schematic diagram of a stereoscopic structure of a cleaning base station according to some embodiments of the present disclosure; and
FIG. 13 is a schematic diagram of a structure of a cleaning system according to some embodiments of the present disclosure.

### DETAILED DESCRIPTION

To make the objectives, technical solutions and advantages of the present disclosure clearer, the present disclosure will be further described in detail below with reference to the accompanying drawings. It is obvious that the described embodiments are only some, but not all of the embodiments of the present disclosure. All other embodiments acquired by those of ordinary skills in the art without creative efforts based on the embodiments in the present disclosure are within the protection scope of the present disclosure.

The terms used in the embodiments of the present disclosure are for the purpose of describing particular embodiments only and are not intended to limit the present disclosure. The singular forms "a/an", "said" and "the" used in the embodiments of the present disclosure and the appended claims are intended to include the plural forms as well, unless otherwise indicated clearly in the context. The term "a plurality of" generally includes at least two.

It should be understood that, the term "and/or" used herein only describes an association relationship between associated objects, and indicates that there may be three kinds of relationships. For example, A and/or B may indicate three cases: A exists alone, both A and B exist, and B exists alone. In addition, the character "/" herein generally indicates an "or" relationship between the contextual objects.

It should be understood that, although the terms first, second, third, etc. may be used to describe in the embodiments of the present disclosure, these should not be limited to these terms. These terms are only used to distinguish. For example, "first" may also be referred to as "second" without departing from the scope of the embodiments of the present disclosure. Similarly, "second" may also be referred to as "first".

It should also be noted that, the terms "including", "containing", or any other variants thereof are intended to cover the nonexclusive inclusion, such that a commodity or device including a series of elements includes not only those elements, but also other elements not listed explicitly or elements inherent to such a commodity or device. Without more limitations, the element defined by the phrase "including a ..." does not exclude the existence of other same elements in the commodity or device including the element.

In the related art, a circuit board is usually provided inside a mobile platform of an automatic cleaning apparatus, and is provided with various electronic devices and port devices. The port devices are electrically connected to various electrically controlled components inside the mobile platform via connecting wires. The electrically controlled components include a driving wheel assembly, and the like. When the automatic cleaning apparatus works in an environment exposed to humidity or water, moisture or water may enter the mobile platform and contact the electronic devices on the circuit board. For example, in an environment exposed to water, when the automatic cleaning apparatus is traveling, a driving wheel may splash water into the mobile platform, and the water may move along connecting wires to the port devices, further enter the circuit board and be in contact with the electronic devices, which may lead to damage to the electronic devices and disable the automatic cleaning apparatus to function properly.

The present disclosure provides an automatic cleaning apparatus, including: a mobile platform; a circuit board, wherein the circuit board is disposed in the mobile platform and includes: a circuit board body having a middle area and a peripheral area around the middle area, a port device disposed on the circuit board body and located in the peripheral area, and an electronic device disposed on the circuit board body and located in the middle area; and a retaining rib, disposed in the mobile platform and configured to prevent liquid and/or moisture from being in contact with the electronic device. In the present disclosure, the retaining rib is disposed in the mobile platform to prevent liquid and/or moisture from being in contact with the electronic device on the circuit board, so that damage to the electronic device is avoided, guaranteeing the service life of the automatic cleaning apparatus.

Optional embodiments of the present disclosure will be described in detail in combination with the accompanying drawings.

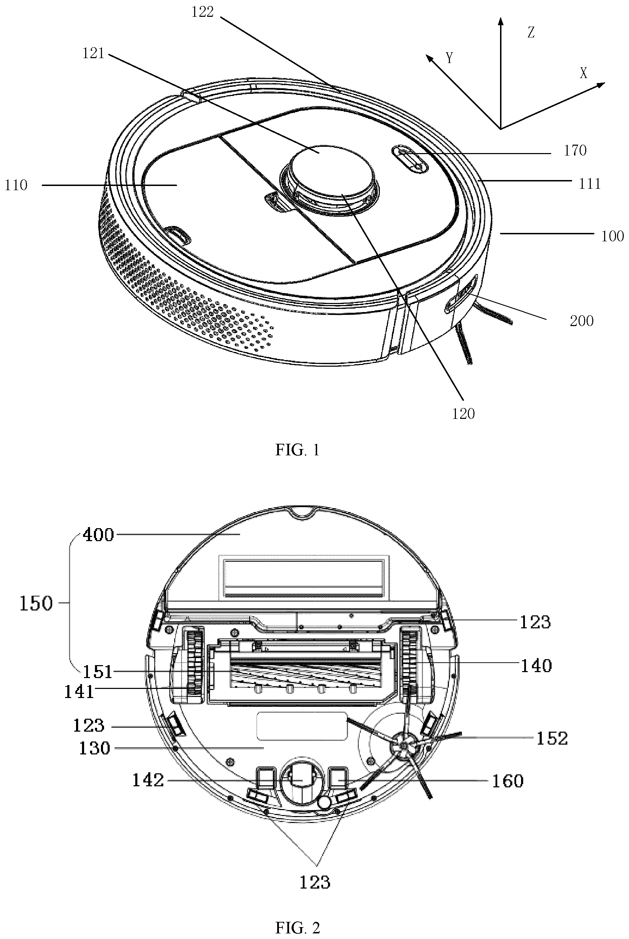

FIG. 1 is a schematic diagram of a structure of an automatic cleaning apparatus according to some embodiments of the present disclosure. FIG. 2 is a schematic diagram of a bottom structure of an automatic cleaning apparatus according to some embodiments of the present disclosure. As shown in FIGs. 1 and 2, the automatic cleaning apparatus may be a vacuum ground sucking robot, or may be a ground mopping/brushing robot, or may be a window climbing robot, or the like. The automatic cleaning apparatus may include a mobile platform 100, a perception system 120, a control system 130, a driving system 140, a cleaning module 150, an energy system 160 and a human-computer interaction system 170.

The mobile platform 100 may be configured to move automatically along a target direction on an operating surface. The operating surface may be a surface to be cleaned by the automatic cleaning apparatus. In some embodiments, the automatic cleaning apparatus may be a ground mopping robot, and thus the automatic cleaning apparatus operates on a ground, and the ground is the operating surface. The automatic cleaning apparatus may also be a window cleaning robot, and thus the automatic cleaning apparatus operates on an outer surface of glass of a building, and the glass is the operating surface. The automatic cleaning apparatus may also be a pipe cleaning robot, and thus the automatic cleaning apparatus operates on an inner surface of a pipe, and the inner surface of the pipe is the operating surface. For the purpose of presentation only, the following description in the present disclosure takes a ground mopping robot as an example for illustration.

In some embodiments, the mobile platform 100 may be an autonomous mobile platform, or a non-autonomous mobile platform. The autonomous mobile platform refers to that the mobile platform 100 itself can automatically and adaptively make an operational decision based on an unexpected environmental input. The non-autonomous mobile platform itself cannot adaptively make an operational decision based on an unexpected environmental input, but can execute a given procedure or operate according to a certain logic. Correspondingly, when the mobile platform 100 is the autonomous mobile platform, the target direction may be determined autonomously by the automatic cleaning apparatus; and when the mobile platform 100 is the non-autonomous mobile platform, the target direction may be set systematically or manually. When the mobile platform 100 is the autonomous mobile platform, the mobile platform 100 includes a forward portion 111 and a rearward portion 110.

As shown in FIGs. 1 and 2, the perception system 120 includes a position determining device 121 located on the mobile platform 100, a buffer 122 located in the forward portion 111 of the mobile platform 100, cliff sensors 123 and sensing devices such as an ultrasonic sensor (not shown), an infrared sensor (not shown), a magnetometer (not shown), an accelerometer (not shown), a gyroscope (not shown), an odometer (not shown), and the like located at a bottom of the mobile platform, for providing various position information and motion state information of the automatic cleaning apparatus to the control system 130.

In order to describe behaviors of the automatic cleaning apparatus more clearly, directions are defined as follows: the automatic cleaning apparatus may travel on the ground by various combinations of movements relative to the following three mutually perpendicular axes defined by the mobile platform 100, i.e., a transversal axis Y, a front and rear axis X and a center vertical axis Z. A forward driving direction along the front and rear axis X is designated as "forward", and a rearward driving direction along the front and rear axis X is designated as "rearward". The transversal axis Y is substantially along a direction of an axis center defined by a center point of a driving wheel assembly 141 extending between a right wheel and a left wheel of the automatic cleaning apparatus. The automatic cleaning apparatus may rotate around the Y axis. It is referred to as "pitch up" when the forward portion of the automatic cleaning apparatus is tilted upward and the rearward portion thereof is tilted downward, and it is referred to as "pitch down" when the forward portion of the automatic cleaning apparatus is tilted downward and the rearward portion thereof is tilted upward. In addition, the automatic cleaning apparatus may rotate around the Z axis. In a forward direction of the automatic cleaning apparatus, it is referred to as "turn right" when the automatic cleaning apparatus is tilted to the right of the X axis, and it is referred to as "turn left" when the automatic cleaning apparatus is tilted to the left of the X axis.

As shown in FIG. 2, the cliff sensors 123 are provided at the bottom of the mobile platform 100 and in front and rear of the driving wheel assembly 141, respectively, for preventing the automatic cleaning apparatus from falling off when the automatic cleaning apparatus retreats, so as to avoid a damage to the automatic cleaning apparatus. The aforementioned "front" refers to a side the same as a travelling direction of the automatic cleaning apparatus, and the aforementioned "rear" refers to a side opposite to the travelling direction of the automatic cleaning apparatus.

The position determining device 121 specifically includes, but is not limited to, a camera and a laser distance sensor (LDS).

Various components in the perception system 120 may operate independently, or operate together to achieve a purpose function more accurately. The surface to be cleaned is identified by the cliff sensors 123 and the ultrasonic sensor to determine physical properties of the surface to be cleaned, including a surface material, a degree of cleanliness, and the like, and may be determined more accurately in combination with the camera, the LDS, or the like.

For example, the ultrasonic sensor may determine whether the surface to be cleaned is a carpet. If the ultrasonic sensor determines that the surface to be cleaned is a carpet material, the control system 130 controls the automatic cleaning apparatus to perform cleaning in a carpet mode.

The forward portion 111 of the mobile platform 100 is provided with the buffer 122. During cleaning, when the driving wheel assembly 141 propels the automatic cleaning apparatus to travel on the ground, the buffer 122 detects one or more events (or objects) in a travelling path of the automatic cleaning apparatus via a sensor system, e.g., an infrared sensor, and the automatic cleaning apparatus may control the driving wheel assembly 141 based on the event (or object), such as an obstacle and a wall, detected by the buffer 122 to cause the automatic cleaning apparatus to respond to the event (or object), for example, to move away from the obstacle.

The control system 130 is disposed on a main circuit board in the mobile platform 100, and includes a computing processor such as a central processing unit and an application processor, that communicates with a non-transitory memory such as a hard disk, a flash memory and a random-access memory. The application processor is configured to receive environmental information sensed by the plurality of sensors and transmitted from the perception system 120, to draw a simultaneous map of an environment where the automatic cleaning apparatus is located using a positioning algorithm e.g., simultaneous localization and mapping (SLAM), based on obstacle information fed back by the LDS, and to autonomously determine a travelling path based on the environmental information and the environmental map, and then to control the driving system 140 to perform operations, such as travelling forward, travelling backward, and/or steering based on the autonomously determined travelling path. Further, the control system 130 may also determine whether to activate the cleaning module 150 to perform a cleaning operation based on the environmental information and the environmental map.

Specifically, the control system 130 may, based on distance information and speed information which are fed back by the buffer 122, the cliff sensors 123 and the sensing devices such as the ultrasonic sensor, the infrared sensor, the magnetometer, the accelerometer, the gyroscope and the odometer, comprehensively determine a current operation state of the ground sweeping robot, such as crossing a threshold, getting on a carpet, locating at an edge of a cliff, being stuck from above or below, having a full dust box or being picked up, and will also give specific next-step action strategies for different situations, so that the operation of the automatic cleaning apparatus is more in line with requirements of an owner and provides better user experience. Further, the control system can plan the most efficient and reasonable cleaning path and cleaning mode based on the simultaneous map drawn by the SLAM, thereby greatly improving the cleaning efficiency of the automatic cleaning apparatus.

The driving system 140 may execute a driving command based on specific distance and angle information, such as x, y, and theta components, to manipulate the automatic cleaning apparatus to travel across the ground. As shown in FIG. 2, the driving system 140 includes the driving wheel assembly 141, and may control a left wheel and a right wheel simultaneously. In order to control the motion of the automatic cleaning apparatus more precisely, the driving system 140 preferably includes a left driving wheel assembly and a right driving wheel assembly. The left driving wheel assembly and the right driving wheel assembly are arranged symmetrically along a transversal axis defined by the mobile platform 100.

In order for the automatic cleaning apparatus to move on the ground more stably or have a higher movement ability, the automatic cleaning apparatus may include one or more steering assemblies 142, wherein the steering assembly 142 may be a driven wheel or a driving wheel, and structurally includes but is not limited to a universal wheel. The steering assembly 142 may be located in front of the driving wheel assembly 141.

The energy system 160 includes a rechargeable battery, such as a nickel-hydride battery and a lithium battery. The rechargeable battery may be connected to a charging control circuit, a battery pack charging temperature detecting circuit and a battery undervoltage monitoring circuit, wherein the charging control circuit, the battery pack charging temperature detecting circuit and the battery undervoltage monitoring circuit are then connected to a single-chip microcomputer control circuit. A host of the automatic cleaning apparatus is connected to a base station (or referred to as a charging pile) through a charging electrode disposed on a side of or below a body of the automatic cleaning apparatus for charging.

The human-computer interaction system 170 includes keys that are on a panel of the host and used by a user to select functions. The human-computer interaction system 170 may further include a display screen and/or an indicator light and/or a horn that present a current state or function item of the automatic cleaning apparatus to the user. The human-computer interaction system 170 may further include a mobile client program. For a route navigation type cleaning apparatus, a mobile client may present a map of the environment where the apparatus is located and a position of the apparatus to the user, which may provide richer and more user-friendly function items to the user.

As shown in FIG. 2, the cleaning module 150 may include a dry cleaning module 151. The dry cleaning module 151 includes a rolling brush, a dust box and a blower. The rolling brush having a certain interference with the ground sweeps up garbage on the ground and rolls up the garbage to the front of a dust suction inlet between the rolling brush and the dust box, and then the garbage is sucked into the dust box by air having a suction force, which is generated by the blower and passes through the dust box. A dust removal capacity of the ground sweeping robot may be characterized by a dust pickup efficiency (DPU) of the garbage. The DPU is affected by a utilization rate of the air in an air channel formed by the dust suction inlet, the dust box, the blower, the air outlet and connecting components between the four, and by a type and power of the blower, which is a complex systematic design problem. Compared to an ordinary plug-in vacuum cleaner, the improvement of the dust removal capacity is more meaningful for an automatic cleaning apparatus with limited energy because the improvement of the dust removal capacity directly and effectively reduces requirements for energy, that is, the original cleaning apparatus that may clean 80 square meters of the ground on a single charge may be evolved to clean 180 square meters or more on a single charge. Furthermore, the service life of the battery with the reduced number of charging times will also be greatly increased, so that the frequency of replacing the battery by the user will also be decreased. More intuitively and importantly, the improvement of the dust removal capacity is the most obvious and important user experience, as the user will directly determine whether thorough cleaning is achieved. The dry cleaning module may further include a side brush 152 having a rotary shaft angled relative to the ground, for moving debris into a region of the rolling brush of the cleaning module 150.

As an optional cleaning module, the automatic cleaning apparatus may further include a wet cleaning module configured to clean at least a part of the operating surface in a wet cleaning manner. The wet cleaning module includes a water tank 400, a cleaning head, a driving unit and the like. Water in the water tank flows to the cleaning head along a waterway, and the cleaning head is driven by the driving unit to clean at least a part of the operating surface.

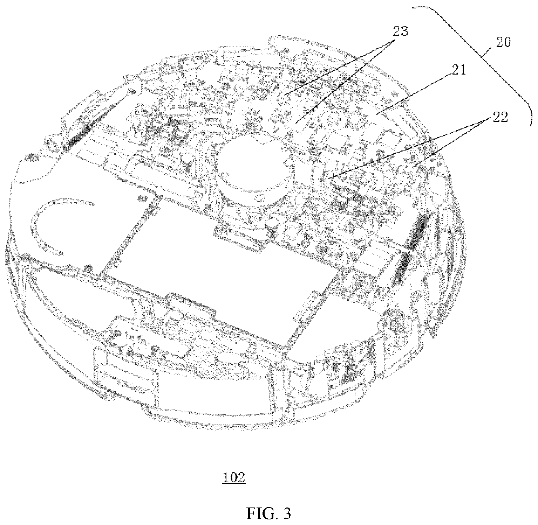

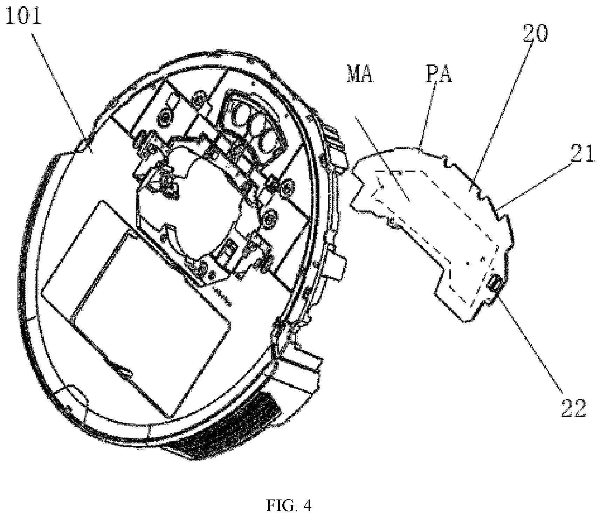

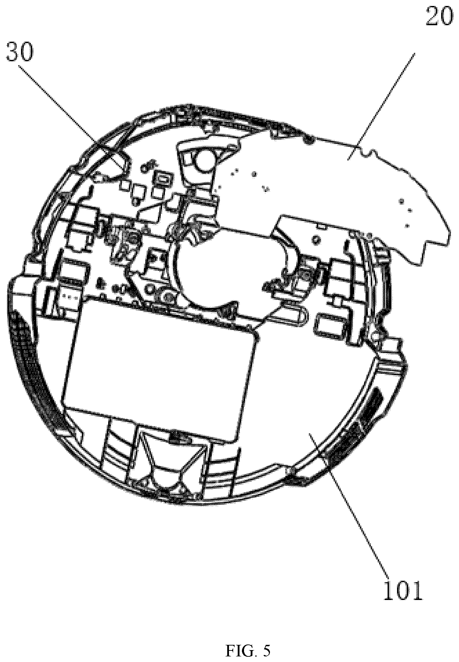

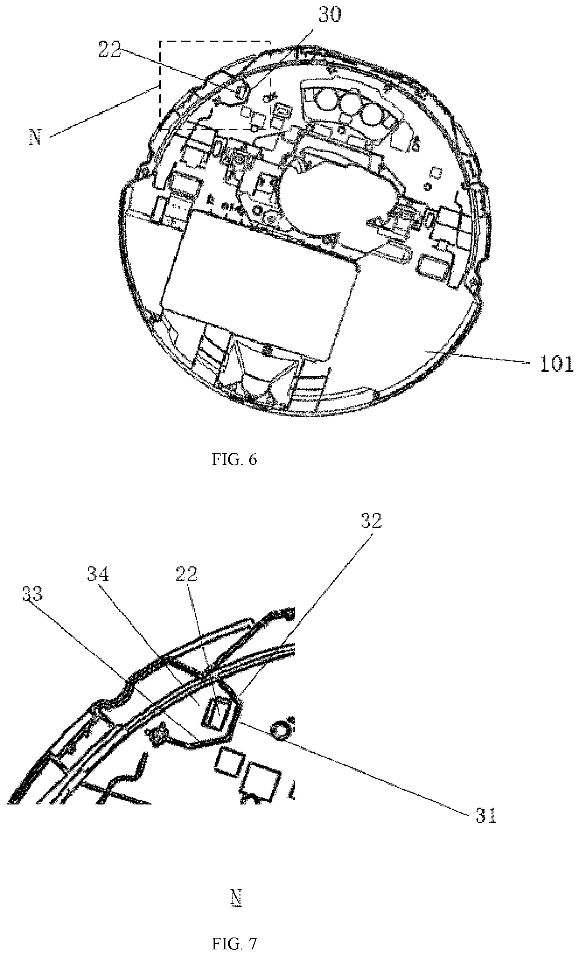

FIG. 3 is a schematic diagram of a structure of a mobile platform body of a mobile platform of an automatic cleaning apparatus according to some embodiments of the present disclosure. FIG. 4 is an exploded schematic diagram of a structure of a mobile platform of an automatic cleaning apparatus according to some embodiments of the present disclosure, wherein no mobile platform body is shown. FIG. 5 is an exploded schematic diagram of a structure of a mobile platform of an automatic cleaning apparatus according to some embodiments of the present disclosure, wherein no mobile platform body is shown. FIG. 6 is a schematic diagram of a structure of a platform cap body of a mobile platform of an automatic cleaning apparatus according to some embodiments of the present disclosure, wherein the positions of port devices are shown. FIG. 7 is an enlarged schematic diagram of an Area N shown in FIG. 6.

As described and shown in FIGs. 1 to 6, some embodiments of the present disclosure provide an automatic cleaning apparatus. The automatic cleaning apparatus is, for example, a vacuum ground sucking robot, a ground mopping/brushing robot, a window climbing robot, and the like. The automatic cleaning apparatus includes a mobile platform 100, a circuit board 20 disposed in the corresponding platform and a retaining rib 30 disposed in the mobile platform.

The mobile platform 100 may be configured to move automatically along a target direction on an operating surface. The operating surface may be a surface to be cleaned by the automatic cleaning apparatus. The circuit board 20 is disposed in the mobile platform 100, and the control center of the automatic cleaning apparatus may be disposed on the circuit board 20 to control and conduct data interaction with various components of the automatic cleaning apparatus.

The circuit board 20 includes a circuit board body 21 as well as port devices 22 and electronic devices 23 which are arranged on the circuit board body. The circuit board body 21 is, for example, a printed circuit board, and has a middle area MA and a peripheral area PA around the MA. The port devices 22 are disposed on the circuit board body 21 and are located in the peripheral area PA. The port devices 22 are connected to other components of the automatic cleaning apparatus, such as the perception system 120, the driving system 140, the cleaning module 150, the energy system 160, the human-computer interaction system 170, and the like, via connecting wires, for example, electric wires, for data communication between the control center and other components of the cleaning apparatus. The electronic devices 23 are disposed on the circuit board body 21 and are located in the middle area MA, and form a control center of the cleaning apparatus, such as the control system 130.

The retaining rib 30 is disposed in the mobile platform 100 and is located between the port devices 22 and the electronic devices 23. The retaining rib 30 is configured to prevent liquid and/or moisture from being in contact with the electronic devices 23, for example, to prevent the liquid and/or moisture reaching the port devices along connecting wires from entering the electronic devices in the middle area, so that damage to the electronic devices is avoided, thereby guaranteeing the service life of the automatic cleaning apparatus.

In some embodiments, as shown in FIGs. 3 to 6, the retaining rib 30 is, for example, of a semi-enclosure structure and is disposed around the port devices 22, the semi-enclosure structure has an open orifice 34, and the open orifice 34 is disposed facing away from the middle area MA.

In some embodiments, as shown in FIGs. 3 to 6, the retaining rib 30 includes a first subordinate retaining rib 31, a second subordinate retaining rib 32 and a third subordinate retaining rib 33. The first subordinate retaining rib 31 is disposed between the port devices 22 and the electronic devices 23, and has a first end part and a second end part. The first subordinate retaining rib 31 is, for example, of a straight strip shape. The second subordinate retaining rib 22 extends from the first end part to the peripheral area PA, and the third subordinate retaining rib 23 extends from the second end part to the peripheral area PA. Each of the second subordinate retaining rib 22 and the third subordinate retaining rib 23 is also, for example, of a straight strip shape. In the direction from the first subordinate retaining rib 31 to the open orifice 34, the second subordinate retaining rib 32 and the third subordinate retaining rib 33 gradually diverge from each other. The first subordinate retaining rib 31, the second subordinate retaining rib 32 and the third subordinate retaining rib 33 form, for example, a trapezoid with an open orifice, and the open orifice is located in the longer base line of the trapezoid.

With such a design, after reaching the port devices 22 along connecting wires, the liquid and/or moisture will be blocked by the retaining rib 30, and the liquid or water resulting from moisture condensation may flow out from the open orifice. Thus, the liquid and/or moisture can be prevented from being in contact with the electronic devices on the circuit board, thereby protecting the electronic devices in the middle area MA of the circuit board.

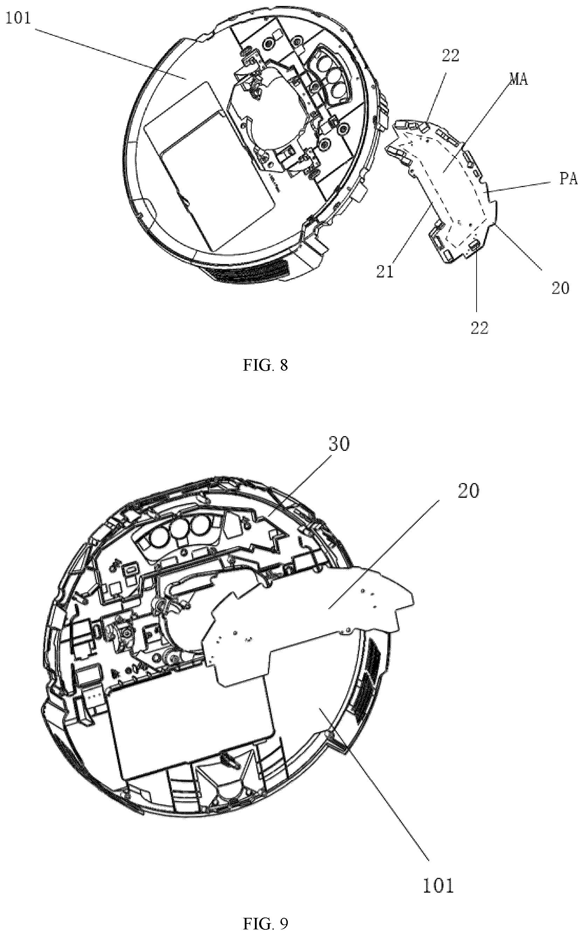

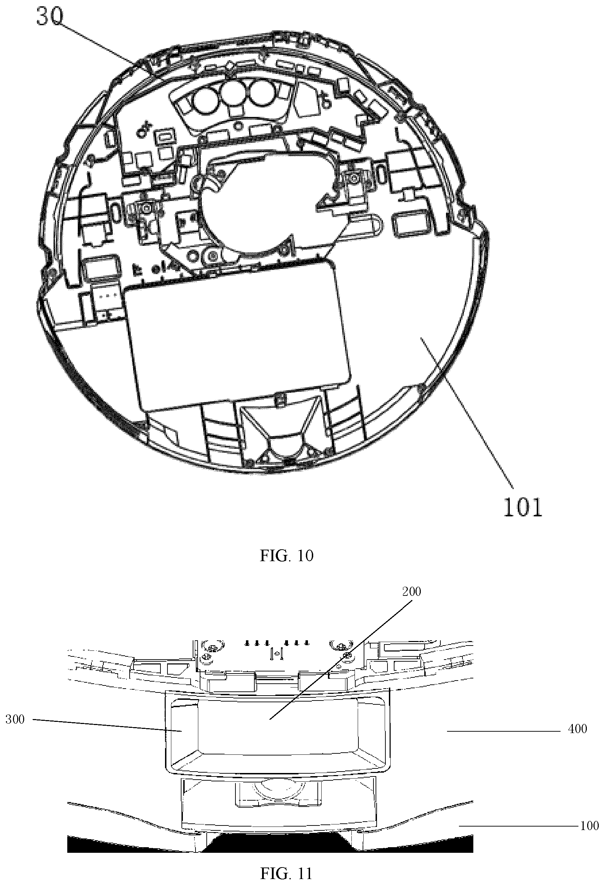

FIG. 8 is an exploded schematic diagram of a structure of a mobile platform of an automatic cleaning apparatus according to some embodiments of the present disclosure, wherein no mobile platform body is shown. FIG. 9 is an exploded schematic diagram of a structure of a mobile platform of an automatic cleaning apparatus according to some embodiments of the present disclosure, wherein no mobile platform body is shown. FIG. 10 is a schematic diagram of a structure of a platform cap body of a mobile platform of an automatic cleaning apparatus according to some embodiments of the present disclosure, in which positions of port devices are shown.

In some embodiments, in combination with FIGs. 3 to 10, a plurality of port devices 22 is provided and is disposed in the peripheral area PA. Any one of the plurality of port devices 22 may be arranged corresponding to the aforementioned retaining rib of the semi-surrounding structure. A plurality of electronic devices 23 is further provided in the middle area MA.

In some embodiments, as shown in FIGs. 3 to 10, the retaining rib 30 may extend along an edge of the middle area is disposed around the electronic device, and is of a full-enclosure structures. The retaining rib 30 isolates the plurality of electronic devices 23 located in the middle area MA from the plurality of port devices 22 located in the peripheral area PA. The retaining rib 30 prevents the liquid and/or moisture reaching the port devices 22 along the connecting wires from entering the middle area MA and being in contact with the electronic devices 23. The retaining rib 30 protects the electronic devices located in the middle area MA from humidity and moisture.

In some embodiments, as shown in FIGs. 1 to 10, the mobile platform 100 includes a mobile platform body 102 and a platform cap body 101. The circuit board 20 is disposed on the mobile platform body 102, and the platform cap body 101 is detachably buckled on the mobile platform body 102 to shield various components on the mobile platform body 102, such as the circuit board 20. The platform cap body 101 shields and protects the various components on the mobile platform body 102.

In some embodiments, the retaining rib 30 is disposed on a surface of the platform cap body 101 facing the mobile platform body 102. When the platform cap body 101 is buckled on the mobile platform body 102, the retaining rib 30 is located between the port devices 22 and the electronic devices 23 to prevent liquid and/or moisture from entering the electronic devices 23.

In some embodiments, when the platform cap body 101 is buckled on the mobile platform body 102, a gap exists between the retaining rib 30 and the circuit board body 21, and the gap d satisfies 0<d≤0.2 mm. That is, the distance between an end surface of the retaining rib 30 distal from the platform cap body 101 and the circuit board body 21 is greater than 0 and less than or equal to 0.2 mm. When liquid, such as water, reaches the gap, the liquid, due to its tension, does not pass through the gap into the middle area MA. In this case, the retaining rib 30 may be made of a hard material, and the gap may further allow a certain mounting tolerance when the platform cap body 101 is assembled to the mobile platform body 102, so that damage to the circuit board 20 caused by the fact that the hard retaining rib abuts against the circuit board 20 is avoided.

In some embodiments, the retaining rib 30 and the platform cap body 101 are of an integrated structure and may be integrally formed through injection molding with the same material.

In some embodiments, when the platform cap body 101 is buckled on the mobile platform body 102, the retaining rib 30 rests against the circuit board body 21. The retaining rib 30 is made of an elastic material, such as foam cotton. When the platform cap body 101 is buckled on the mobile platform body 102, the retaining rib 30 is pressed and deformed to form a sealing structure so as to prevent the liquid and/or moisture reaching the port devices 22 along connecting wires from entering the middle area MA and being in contact with the electronic devices 23.

In some embodiments, the retaining rib 30 may further be directly disposed on the circuit board body 21. When the platform cap body 101 is buckled on the mobile platform body 102, an end part of the retaining rib 30 distal from the circuit board body 21 abuts against a surface of the platform cap body 101 facing the circuit board 20, or, the distance between the end part of the retaining rib 30 distal from the circuit board body 21 and the surface of the platform cap body 101 facing the circuit board 20 is greater than 0 and less than or equal to 0.2 mm, so as to prevent the liquid and/or moisture reaching the port devices 22 along the connecting wires from entering the middle area MA and being in contact with the electronic devices 23.

After the cleaning is completed or during the cleaning process, the automatic cleaning apparatus needs to return to the base station for garbage collection or charging. During this process, the automatic cleaning apparatus needs to accurately find a pile signal sent from the base station. When the automatic cleaning apparatus communicates with the base station, the automatic cleaning apparatus acts as a signal receiving end to receive a signal sent from the base station. During the alignment process between the automatic cleaning apparatus and the base station, the automatic cleaning apparatus does not desire to receive excessive stray interference signals. For example, if the automatic cleaning apparatus is located on a side of the base station and a signal is reflected to the receiving end in a signal receiving window through an edge of the window, causing the automatic cleaning apparatus to enter the base station obliquely from the side of the base station. As a result, the charging port cannot be aligned or the garbage recycling port cannot be aligned after the automatic cleaning apparatus enters the base station, failing to complete the task of returning to the base station.

According to a specific implementation of the present disclosure, a cleaning apparatus is provided, and includes: a mobile platform 100, configured to automatically move on an operating surface; a pile searching module 200, disposed on a side of the mobile platform and configured to identify the position of a base station after a pile signal is received; and a stray light extinction structure 300, configured to extinct interference signals of the pile signal when the pile searching module 200 receives the pile signal.

The cleaning apparatus is separated from the base station. When the cleaning apparatus needs to be charged or to dump garbage, the cleaning apparatus is docked with the base station. When the cleaning apparatus performs cleaning, the cleaning apparatus is separated from the base station for the cleaning operation. The base station includes an infrared transmitting device for transmitting infrared signals. Understandably, when the cleaning apparatus needs to return to the base station, the cleaning apparatus needs to receive an infrared signal transmitted from the base station so as to perform operations such as positioning, pile searching and pile docking.

The stray light extinction structure is provided around a signal sending and receiving window of the automatic cleaning apparatus. When the pile searching module receives the pile signals, the stray light extinction structure can extinct an interference signal of the pile signal, so that the automatic cleaning apparatus can more accurately receive signals transmitted from the base station and accurately identify the position of the base station so as to accurately return to the base station for self-cleaning or charging.

As shown in FIG. 11, a cleaning apparatus includes the pile searching module 200. The pile searching module 200 is disposed on a side of the mobile platform, as shown in FIG. 1, for example, on a front side surface or a rear side surface or an oblique side surface in the forward direction of the mobile platform 100, and is configured to receive an infrared signal transmitted from the base station. When the cleaning apparatus needs to return to the base station, a controller controls the pile searching module 200 to search for an infrared signal near the base station. When the pile searching module 200 receives the infrared signal, the controller guides the cleaning apparatus to be docked with the base station based on the infrared signal. After the cleaning apparatus is docked with the base station, the cleaning apparatus can perform bidirectional communication with the base station.

In some embodiments, the pile searching module 200 includes a signal window. For example, an infrared receiving unit and an infrared transmitting unit are disposed in the signal window for receiving and transmitting infrared signals, respectively. The received infrared signal may be a signal transmitted from a base station. A light source for transmitting the infrared signal may be an infrared LED, a line light source, and the like. The infrared signal may be received by an infrared sensor, such as an infrared CCD. Understandably, the received signal is not limited to the infrared signal but may be visible light signals or other radio frequency signals as long as communication can be achieved. The signal window may be formed by an optical lens or a high-transmittance material passing through signals with desired wavelengths. The stray light extinction structure 300 is disposed at an edge position of the signal window, for example, around the signal window in a full-enclosure manner or a semi-enclosure manner or any local enclosure manner. Generally, a signal window is surrounded by a stray light extinction structure 300 to form a concave window structure for receiving and transmitting signals.

In some embodiments, the stray light extinction structure 300 is an oblique surface surrounding the signal window, and the oblique surface may have an inclination of 70 degrees to 90 degrees for collecting signals transmitted from the base station. Usually, light signals with undesired wavelengths are filtered through the signal window, and signals transmitted from the base station can be incident perpendicularly on the signal window and sensed on the signal window to achieve matched communication between the cleaning apparatus and the base station. However, when a pile signal is injected into the oblique surface surrounding the signal window, the pile signal light will be reflected to the signal window and the pile signal will be sensed by a sensor inside the signal window, so that the cleaning apparatus can position the base station. However, since the sensed signal is the reflected light signal from the oblique surface, positioning deviation is inevitably caused, resulting in positioning inaccuracy and failure to achieve complete alignment between the cleaning apparatus and the base station. Therefore, it is required to extinct the pile signal reflected through the oblique surface. As an implementation, the oblique surface may be disposed as a rough surface, and after a pile signal is injected into the rough oblique surface, diffuse reflection occurs, and the diffusely reflected light signal will be transmitted in all directions. Thus, the intensity of the signal entering the signal window will be inevitably reduced to be lower than the threshold of the signal to be sensed. In this way, the pile signal is not considered as a valid pile signal, and the controller does not control the cleaning apparatus to perform docking based on the signal.

In some embodiments, the stray light extinction structure 300 is an oblique surface surrounding the signal window, and the oblique surface is black or translucent black. Since black has a large absorption coefficient for light signals, after a pile signal is injected into a black or translucent black oblique surface, no total reflection occurs, or the reflectivity is extremely low. Therefore, the intensity of the signal entering the signal window is lower than the threshold of the signal to be sensed. In this way, the pile signal is not considered as a valid pile signal, and the controller does not control the cleaning apparatus to perform docking based on the signal.

In some embodiments, the stray light extinction structure 300 is an oblique surface surrounding the signal window, and the oblique surface is provided with a light absorption layer, for example, being coated with a light-absorbing material or covered by a light absorption layer. After a pile signal is injected into the oblique surface provided with the light absorption layer, most of the light rays are absorbed and no reflection occurs, or the reflectivity is extremely low. Therefore, the intensity of the signal entering the signal window is lower than the threshold of the signal to be sensed. In this way, the pile signal is not considered as a valid pile signal, and the controller does not control the cleaning apparatus to perform docking based on the signal.

In some embodiments, the stray light extinction structure 300 is an oblique surface surrounding the signal window, and the oblique surface is provided with a light extinction structure. In some embodiments, the light extinction structure includes a micro protrusion disposed on the oblique surface. In some embodiments, the micro protrusion includes at least one of the following: an arc-shaped protrusion, a cone-shaped protrusion or a prismatic protrusion. Providing the light extinction structure having the plurality of micro protrusions on the oblique surface also significantly reduces the reflectivity of the pile signal on the oblique surface. Therefore, the intensity of the signal entering the signal window is lower than the threshold of the signal to be sensed. In this way, the pile signal is not considered as a valid pile signal, and the controller does not control the cleaning apparatus to perform docking based on the signal.

In some embodiments, the stray light extinction structure 300 is a vertical surface surrounding the signal window, and the vertical surface is perpendicular to the signal window. When the structure disposed around the signal window is a vertical surface perpendicular to the window plane, the energy of a pile signal injected from a side of the cleaning apparatus into the signal window is significantly reduced. Therefore, the intensity of the signal entering the signal window is lower than the threshold of the signal to be sensed. In this way, the pile signal is not considered as a valid pile signal, and the controller does not control the cleaning apparatus to perform docking based on the signal.

In some embodiments, as shown in FIG. 11, the mobile platform 100 includes a water tank 400 for accommodating water used for cleaning. The water tank 400 is usually disposed on a rear side of the mobile platform 100. The water tank 400 and the mobile platform 100 are of a detachable structure or of an integrated structure. The stray light extinction structure 300 is integrally formed with or separately formed with the water tank 400. That is, the stray light extinction structure 300 may be formed as a surrounding-type oblique surface or vertical surface integrally during the manufacturing of the water tank 400, or may be an oblique surface or vertical surface disposed around the signal window through bonding or clamping, which is not limited.

As for the automatic cleaning apparatus according to the present disclosure, the arrangement of the stray light extinction structure around the signal receiving and transmitting window may be one or more combinations of the aforementioned implementations. When the pile searching module receives the pile signal, the stray light extinction structure can extinct an interference signal of the pile signal, such as a pile signal injected from an oblique direction, so that the automatic cleaning apparatus can more accurately receive a signal transmitted from the base station in a correct direction and accurately identify the position of the base station based on the signal in the correct direction so as to accurately return to the base station for self-cleaning or charging.

According to a specific embodiment of the present disclosure, the present disclosure provides a cleaning system, including: a cleaning base station and any one of the above cleaning apparatuses.

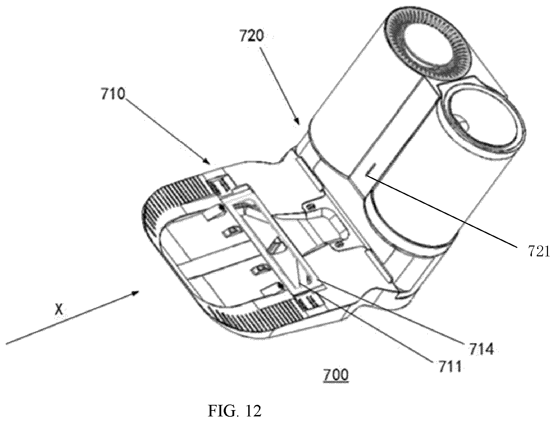

FIG. 12 is a schematic structural diagram of a cleaning base station according to some embodiments of the present disclosure. The cleaning base station 700 is configured to provide garbage collection and/or automatic charging for the automatic cleaning apparatus.

As shown in FIG. 12, the cleaning base station 700 includes a cleaning base station base 710 and a cleaning base station main body 720. The cleaning base station main body 720 is configured to collect garbage in a dust box of the automatic cleaning apparatus, and is disposed on the cleaning base station base 710. The cleaning base station base 710 includes a dust collection port 711 and a conductive sheet, the dust collection port 711 is configured to be docked with the port of the main brush module of the automatic cleaning apparatus, the garbage in the dust box of the automatic cleaning apparatus enters the cleaning base station main body 720 through the dust collection port 711, and the conductive sheet is configured to charge the cleaning apparatus entering the cleaning base station base 710. In some embodiments, as shown in FIG. 12, a sealing rubber pad 714 is also disposed around the dust collection port 711, and is used for sealing the dust collection port 711 and the port of the main brush module of the automatic cleaning apparatus after they are docked to prevent garbage leakage. The cleaning base station main body 720 is provided with a signal transmitting port 721 used for transmitting a pile signal. After the cleaning apparatus captures the pile signal, the cleaning apparatus performs communication, so that accurate docking between the cleaning apparatus and the base station can be achieved.

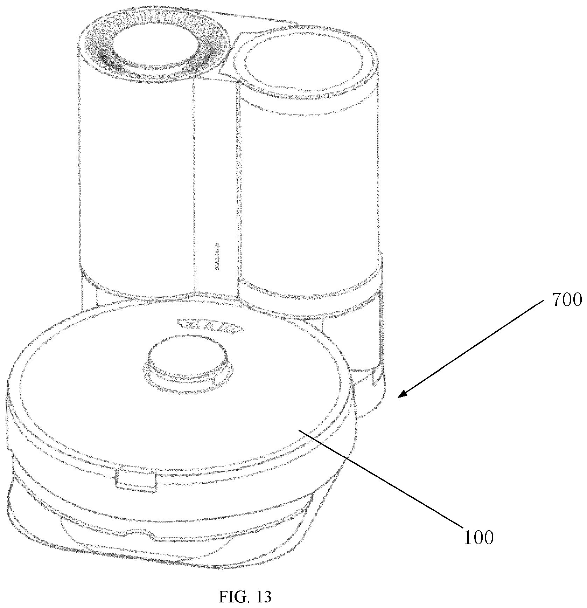

FIG. 13 is a schematic diagram of a scene after the automatic cleaning apparatus returns to the cleaning base station according to some embodiments of the present disclosure. As shown in FIG. 13, when the mobile platform 100 of the automatic cleaning apparatus, such as a sweeping robot, returns to the cleaning base station 700 after completing the cleaning, the automatic cleaning apparatus moves onto the cleaning base station base 710 in the X direction, so that the port of the main brush module of the automatic cleaning apparatus is docked with the dust collection port 711 to transfer the garbage in the dust box of the automatic cleaning apparatus to a garbage bag of the cleaning base station, or so that the charging conductive sheet of the base station is docked with a charging port of the cleaning apparatus for charging.

Finally, it should be noted that various embodiments in the Description are described in a progressive manner, each embodiment focuses on the differences from other embodiments, and the same or similar parts among the various embodiments may refer to one another.

The above embodiments are only used for illustrating the technical solutions of the present disclosure and are not intended to limit the present disclosure. Although the present disclosure has been described in detail with reference to the foregoing embodiments, those of ordinary skills in the art should understand that, they can still make modifications to the technical solutions described in the foregoing embodiments or make equivalent substitutions to part of the technical features; and these modifications or substitutions do not make the essence of the corresponding technical solutions deviate from the spirit and scope of the technical solutions of the various embodiments of the present disclosure.

## Claims

1. An automatic cleaning apparatus, comprising:
a mobile platform;
a circuit board, disposed in the mobile platform and comprising:
a circuit board body having a middle area and a peripheral area around the middle area,
a port device, disposed on the circuit board body and located in the peripheral area, and
an electronic device, disposed on the circuit board body and located in the middle area; and
a retaining rib, disposed between the port device and the electronic device, and configured to prevent liquid and/or moisture from being in contact with the electronic device.

2. The automatic cleaning apparatus according to claim 1, wherein the retaining rib is of a semi-enclosure structure and is disposed around the port device, the semi-enclosure structure is provided with an open orifice, and the open orifice is disposed facing away from the middle area.

3. The automatic cleaning apparatus according to claim 2, wherein the retaining rib comprises:
a first subordinate retaining rib, disposed between the port device and the electronic device, and having a first end part and a second end part;
a second subordinate retaining rib, extending from the first end part to the peripheral area; and
a third subordinate retaining rib, extending from the second end part to the peripheral area, wherein
in a direction from the first subordinate retaining rib to the open orifice, the second subordinate retaining rib and the third subordinate retaining rib gradually diverge from each other.

4. The automatic cleaning apparatus according to claim 1, wherein the retaining rib extends along an edge of the middle area, is disposed around the electronic device, and is of a full-enclosure structure.

5. The automatic cleaning apparatus according to any one of claims 1 to 4, wherein the mobile platform comprises:
a mobile platform body, on which the circuit board is disposed; and
a platform cap body, detachably buckled on the mobile platform body to shield the circuit board, wherein
the retaining rib is disposed on a surface of the platform cap body facing the mobile platform body.

6. The automatic cleaning apparatus according to claim 5, wherein when the platform cap body is buckled on the mobile platform body, a gap exists between the retaining rib and the circuit board body, and the gap d satisfies 0<d≤0.2 mm.

7. The automatic cleaning apparatus according to claim 6, wherein the retaining rib and the platform cap body are of an integrated structure.

8. The automatic cleaning apparatus according to claim 5, wherein when the platform cap body is buckled on the mobile platform body, the retaining rib rests against the circuit board body.

9. The automatic cleaning apparatus according to claim 8, wherein the retaining rib is made of an elastic material.

10. The automatic cleaning apparatus according to any one of claims 1 to 4, wherein the retaining rib is disposed on the circuit board body.

11. A cleaning apparatus, comprising:
a mobile platform, configured to move on an operating surface;
a pile searching module, disposed on a side of the mobile platform and configured to receive a pile signal transmitted from a base station so as to identify a position of the base station; and
a stray light extinction structure, configured to extinct an interference signal of the pile signal when the pile searching module receives the pile signal.

12. The cleaning apparatus according to claim 11, wherein the pile searching module comprises a signal window configured to receive the pile signal, and the stray light extinction structure is disposed at an edge position of the signal window.

13. The cleaning apparatus according to claim 12, wherein the stray light extinction structure surrounds the signal window.

14. The cleaning apparatus according to claim 13, wherein the stray light extinction structure is an oblique surface surrounding the signal window, and the oblique surface is a rough surface.

15. The cleaning apparatus according to claim 13, wherein the stray light extinction structure is an oblique surface surrounding the signal window, and the oblique surface is black or translucent black.

16. The cleaning apparatus according to claim 13, wherein the stray light extinction structure is an oblique surface surrounding the signal window, and the oblique surface is provided with a light absorption layer.

17. The cleaning apparatus according to claim 13, wherein the stray light extinction structure is an oblique surface surrounding the signal window, and the oblique surface is provided with a light extinction structure.

18. The cleaning apparatus according to claim 17, wherein the light extinction structure comprises a micro protrusion disposed on the oblique surface.

19. The cleaning apparatus according to claim 18, wherein the micro protrusion comprises at least one of the following: an arc-shaped protrusion, a cone-shaped protrusion or a prismatic protrusion.

20. The cleaning apparatus according to claim 13, wherein the stray light extinction structure is a vertical surface surrounding the signal window, and the vertical surface is perpendicular to the signal window.

21. The cleaning apparatus according to claim 11**,** wherein the mobile platform comprises a water tank, and the stray light extinction structure is integrally formed with or separately formed with the water tank.

22. A cleaning system, comprising: a cleaning base station and the cleaning apparatus according to any one of claims 11 to 21.
